# FASCICULE DE BREVET EUROPEEN

(11) **EP 0 472 481 B1**
(45) Date de publication et mention de la délivrance du brevet: **13.11.1996**
(21) Numéro de dépôt: 91420295.7
(22) Date de dépôt: 14.08.1991
(51) Int. Cl.: H01L 29/74, H01L 29/747, H01L 29/06

(54) **Composant semiconducteur haute tension à faible courant de fuite**
Hochspannungshalbleiteranordnung mit kleinem Leckstrom
High voltage semiconductor device having low leakage current

(30) Priorité: 21.08.1990 FR 9010738
(43) Date de publication de la demande: 26.02.1992
(73) Titulaire: SGS-THOMSON MICROELECTRONICS S.A., F-94250 Gentilly (FR)
(72) Inventeur: Poulin, François, F-37000 Tours (FR)
(74) Mandataire: de Beaumont, Michel

(56) Documents cités:
- DE-A- 2 021 691
- FR-A- 2 305 854
- PATENT ABSTRACTS OF JAPAN vol. 4, no. 32 (E-2)(514) 19 Mars 1980 & JP- A-55 006 847 ( MITSUBISHI DENKI K.K. ) 18 Janvier 1980

## Description

La présente invention concerne une structure de composant semiconducteur à caisson d'isolement susceptible de bloquer une tension appliquée selon l'une ou l'autre polarité sur ses bornes principales.

La description ci-après concerne plus particulièrement le cas d'un thyristor mais il sera clair pour l'homme de l'art que la présente invention s'applique de façon générale à des composants semiconducteurs à caisson comprenant des jonctions bloquantes de part et d'autre d'une région semiconductrice à faible niveau de conductivité.

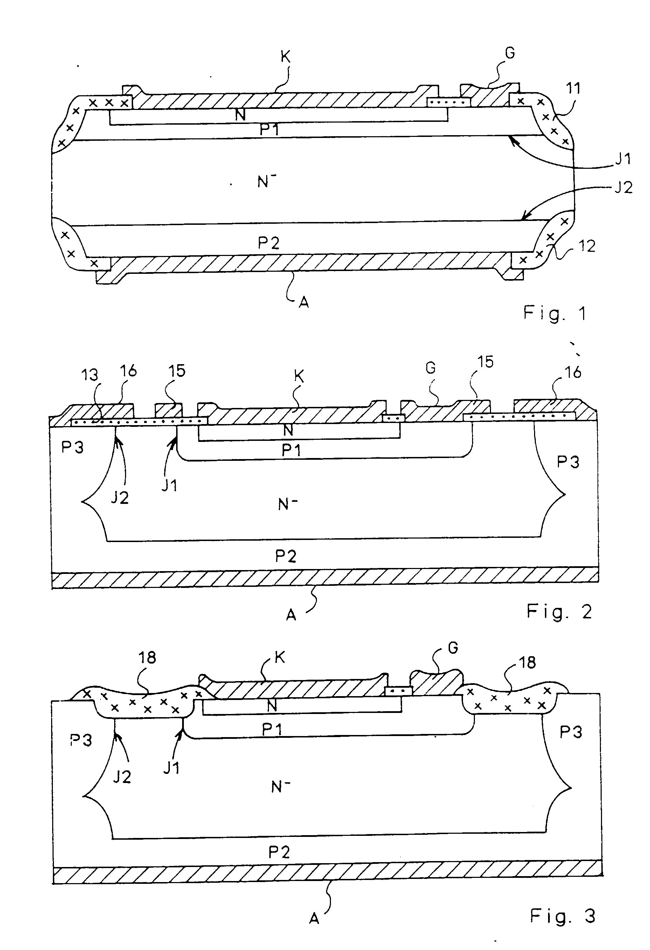

L'état de la technique va d'abord être rappelé en relation avec les figures 1 à 4 qui représentent des vues en coupe schématiques de divers types de thyristor. Il sera clair pour l'homme de l'art que ces figures ne sont pas tracées à l'échelle mais que les dimensions et épaisseurs des diverses régions sont arbitrairement dilatées pour faciliter le tracé et la lisibilité des figures, comme cela est d'usage dans le domaine de la représentation des composants semiconducteurs.

Un thyristor est un composant semiconducteur à quatre couches : une couche de cathode N, une couche de base P₁, une région de substrat N⁻ et une couche d'anode P₂. Une métallisation de cathode K est solidaire de la couche de cathode N, une métallisation de gâchette G est en contact avec une partie de la couche de base P₁, et une métallisation d'anode A est solidaire de la couche d'anode P₂. Le thyristor peut bloquer une tension positive ou négative appliquée entre ses bornes principales A et K et peut laisser passer un courant résultant de l'application d'une tension positive entre anode et cathode quand un courant est injecté dans la gâchette.

En polarisation directe (anode positive, cathode négative) et en l'absence de signal de gâchette, c'est la jonction J₁ entre la région N⁻ et la couche P₁qui est bloquante. En polarisation inverse (anode négative et cathode positive) c'est la jonction J₂ entre la couche P₂ et la région N⁻ qui est bloquante.

En théorie, la tension de claquage de ces jonctions dépend du gradient de dopage entre le couches P₁ et N⁻ d'une part et entre les couches P₂ et N⁻ d'autre part ainsi que de l'épaisseur de la région N⁻. En pratique, les tensions de claquage sont essentiellement déterminées par la qualité du périmètre des jonctions au niveau des surfaces externes du composant qui sera appelé ci-après périmètre apparent des jonctions.

La figure 1 représente un thyristor dit de type "mésa", dans lequel les périphéries supérieure et inférieure du thyristor sont sillonnées, le sillon supérieur traversant la jonction J₁ et le sillon inférieur traversant la jonction J₂. Ces sillons sont glassivés, c'est-à-dire remplis d'un verre désigné par la référence 11 pour le sillon supérieur et par la référence 12 pour le sillon inférieur. Ainsi, les surfaces supérieure et inférieure du thyristor forment des plateaux, des mésas. L'inclinaison des sillons au niveau du périmètre apparent des jonctions J₁ et J₂, leur fini, et la qualité de la passivation sont autant de paramètres qui ont été bien étudiés et qui fixent la tension de claquage des jonctions. Actuellement, c'est ce type de structure qui permet d'obtenir les thyristors supportant les plus hautes tensions (supérieures au millier de volts).

Toutefois, la technologie de type mésa présente un certain nombre de limites fondamentales ; en particulier, elle n'est pas compatible avec les processus usuels d'assemblage automatisé. Pour résoudre ce problème, on a développé des structures de type à caisson, telles que celles illustrées en figures 2 et 3 dans lesquelles des diffusions profondes de type P, P₃, sont formées à la périphérie du thyristor et sont en continuité électrique avec la couche P₂. La région N⁻ remonte au niveau de la surface supérieure du thyristor et les périmètres apparents des jonctions J₁ et J₂ sont sur cette surface supérieure.

La figure 2 représente le mode le plus simple de passivation des jonctions J₁ et J₂ selon lequel, conformément à la technologie planar classique, les périmètres apparents des jonctions sont passivés par une simple couche d'oxyde 13. Pour améliorer la tenue en tension de ces jonctions, on forme au-dessus de chaque jonction une métallisation dite plaque de champ. La première plaque de champ 15 recouvre la jonction J₁ et est solidaire électriquement de la région P₁ ou de la gâchette G. La deuxième plaque de champ 16 recouvre la jonction J₂ et est solidaire électriquement du caisson P₃. La longueur dont chacune de ces plaques de champ déborde au-dessus de la région N⁻ est un paramètre déterminant de la tenue en tension de la jonction sous-jacente. Toutefois, avec de telles structures, on n'arrive pas à atteindre de tenues en tension de jonctions supérieures à quelques centaines de volts, au mieux 400 volts. Pour améliorer ce résultat, on a également prévu de revêtir les plaques de champ et l'intervalle entre les plaques de champ d'une couche de passivation supplémentaire d'origine minérale (SiO₂ déposé par voie chimique en phase vapeur et nitrure de silicium) ou organique (polyimide) mais ceci complique considérablement le procédé pour un gain relativement faible. On atteint alors au mieux des tenues en tension de l'ordre de 600 volts. Une structure de ce type apparaît par exemple dans Patent Abstract of Japan, Vol. 4, N° 32 (E-2)(514), mars 1980.

On notera que dans les structures des figures 1 et 2, il ne se pose pas de problème de courant de fuite, c'est-à-dire que, quand les jonctions sont polarisées en inverse, le courant de fuite circulant éventuellement entre anode et cathode est inférieur au microampère.

La figure 3 illustre une solution connue pour améliorer la tenue en tension d'un thyristor à caisson (voir, par exemple, DE-A-20 21 691). La surface apparente de la région N⁻ est sillonnée et le sillon est rempli d'un verre 18 dans lequel débouchent les jonctions J2 et J1. On obtient alors une tenue en tension satisfaisante, du même ordre de grandeur que celle obtenue avec les thyristors de type mesa. Toutefois, un nouveau problème se pose, à savoir l'apparition de courants de fuite relativement importants, notamment à chaud, quand le thyristor est en situation de blocage direct ou inverse. Ce courant de fuite n'est pas stable dans le temps et peut atteindre des valeurs de quelques dizaines, voire quelques centaines de microampères.

L'apparition du courant de fuite dans la structure de la figure 3 peut être attribuée à une accumulation de charges négatives fixes et/ou mobiles dans le verre 18.

Dans le cas d'une structure mesa telle que celle de la figure 1, l'effet de ces charges est d'augmenter la tension de claquage de chacune des jonctions J₁ et J₂ en compensant localement la concentration N du silicium de la région intrinsèque (N⁻).

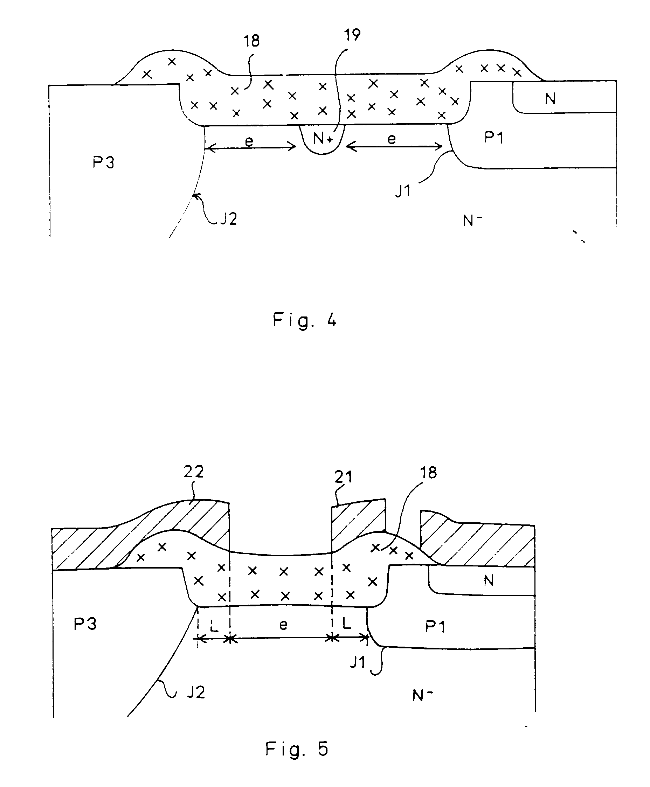

Dans le cas de la structure de la figure 3, cette présence de charges négatives dans le verre 18 conduit à inverser le type de conductivité de la partie superficielle de la région N⁻ et à y créer un canal entraînant la présence d'un courant de fuite. Pour remédier à cet inconvénient, on a suggéré dans l'art antérieur des structures du type de celle de la figure 4 comprenant au centre de la partie superficielle de région N⁻ une diffusion N⁺ 19 dite d'arrêt de canal. Ceci permet de réduire fortement le courant de fuite qui devient alors inférieur au microampère. Toutefois, une telle structure présente plusieurs inconvénients à savoir d'une part sa difficulté de réalisation qui implique des étapes de fabrication supplémentaires, et d'autre part le fait que la distance e entre la limite de chaque jonction et la région N⁺ 19 doit être supérieure ou égale à l'épaisseur de la région N⁻.

Une structure du type de celle de la figure 4 est par exemple décrite dans le document EP-A-2 305 854 qui suggère également une structure à double sillonnage. Ce document propose en outre d'utiliser des plaques de champ pour leur fonction classique d'étalement des lignes de champ et non pas pour la réduction du courant de fuite. La structure proposée dans ce document présente l'inconvénient évident d'occuper une surface de silicium importante.

L'objet de la présente invention est de prévoir une structure de composant semiconducteur, par exemple de thyristor, présentant les avantages des structures à caisson mais évitant les courants de fuite à l'état de blocage sans augmenter la surface de silicium occupée par le composant.

Pour atteindre ces objets, la présente invention prévoit un composant semiconducteur haute tension comprenant une région centrale d'un premier type de conductivité faiblement dopée encadrée de couches du deuxième type de conductivité à plus fort niveau de dopage formant avec la région centrale des première et seconde jonctions susceptibles supporter ladite haute tension, dans lequel les première et seconde jonctions affleurent sur une même surface principale du composant, de part et d'autre d'une surface apparente de ladite région centrale, et dans lequel un sillon est formé dans toute ladite surface apparente et est rempli d'un verre de passivation. La surface du verre est recouverte, au-dessus du contour de chaque jonction, d'une métallisation en contact avec la couche du deuxième type de conductivité correspondant à cette jonction.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 à 3 sont des vues en coupe schématique de thyristors selon l'art antérieur ;
la figure 4 est une vue en coupe partielle d'une région d'isolement de jonction classique résolvant le problème posé; et
la figure 5 est une vue en coupe partielle d'une région d'isolement de jonction résolvant le problème posé selon la présente invention.

La présente invention propose, pour supprimer les courants de fuite, comme cela est représenté en figure 5, de prévoir des métallisations 21 et 22, au-dessus de la couche de glassivation 18, respectivement au-dessus des jonctions J₁ et J₂. La métallisation 21 au-dessus de la jonction J₁ est solidaire (non représenté) de la région P₁ et la métallisation 22 au-dessus de la jonction J₂ est solidaire du caisson P₃.

Ces métallisations, bien que d'aspect similaire aux plaques de champ de la figure 2, n'ont pas la même fonction et ne sont pas dimensionnées en fonction des mêmes paramètres.

Ces métallisations servent, par effet électrostatique, à neutraliser la région de canal en appliquant un champ inverse à celui des charges négatives existant dans la glassivation 18. Quand la jonction J₁ est bloquante, la région P₃ qui se trouve à un potentiel positif communique ce potentiel à la métallisation 22 qui sert à annuler le canal. On notera qu'ici c'est la métallisation opposée à la jonction bloquante qui joue un rôle actif. Contrairement au cas des plaques de champ de la figure 2, la distance L entre une jonction et la projection de l'extrémité de la métallisation superposée n'est pas critique. Une distance L de l'order de 10 micromètres est suffisante pour obtenir l'effet d'annulation du canal. C'est la distance entre les deux métallisations qui est déterminante pour la tenue en tension et qui doit être au moins égale à la distance e de la figure 4. Ainsi, du fait que L est très inférieur à e, la distance entre les périmètres apparents des deux jonctions (e+2L) est, dans le cas de la figure 5, très inférieure au cas de la figure 4 où elle est supérieure à 2e. On peut donc grâce à la présente invention obtenir une structure plus compacte. En outre, la réalisation de métallisations selon la présente invention n'implique aucune étape supplémentaire de fabrication par rapport aux étapes de fabrication normales d'un thyristor.

Comme on l'a noté en tête de la présente invention, bien que l'invention ait été décrite en relation avec un thyristor pour simplifier l'exposé, il est clair que des configurations similaires à celle illustrée en figure 5 peuvent apparaître dans tout composant haute tension à blocage bidirectionnel, par exemple des triacs, et que la présente invention s'appliquera de même à ces autres composants.

## Revendications

1. Composant semiconducteur haute tension à faible courant de fuite comprenant une région centrale (N⁻) d'un premier type de conductivité faiblement dopée encadrée de couches (P₁, P₃) du deuxième type de conductivité à plus fort niveau de dopage formant avec la région centrale des première et seconde jonctions (J₁, J₂) susceptibles de supporter ladite haute tension, dans lequel les première et seconde jonctions affleurent sur une même surface principale du composant, de part et d'autre d'une surface apparente de ladite région centrale, et dans lequel un sillon est formé dans toute ladite surface apparente et est rempli d'un verre de passivation (18), caractérisé en ce que la surface du verre est recouverte, au-dessus du contour de chaque jonction, d'une métallisation (21, 22) en contact avec la couche du deuxième type de conductivité correspondant à cette jonction et qui s'étend sur une distance (L), faible devant l'épaisseur (e) de la région centrale, au-dessus de la surface de ladite région centrale.

2. Composant semiconducteur haute tension selon la revendication 1, constituant un thyristor formé à partir d'un substrat (N-) faiblement dopé constituant ladite région centrale, une deuxième couche de type P (P₂) étant formée sur toute la surface inférieure du thyristor et des diffusions profondes de type P (P₃) se rejoignant à la périphérie du thyristor, la région de contact entre le caisson diffusé opposé à ladite deuxième couche de type P et ladite région centrale formant le périmètre apparent de la seconde jonction, et une première région de type P (P₁) étant formée dans une partie de la surface supérieure de la région principale, sans entrer en contact avec le caisson et constituant en surface avec ladite région centrale la première jonction, une région de cathode (N⁺) étant formée dans la première région de type P.

## Patentansprüche

1. Hochspannungshalbleiter-Anordnung mit kleinem Leckstrom, mit einem zentralen Bereich (N⁻) eines ersten schwach dotierten Leitungstypes, der von Schichten (P₁, P₂) eines zweiten Leitungstypes mit einem wesentlich höheren Dotierungsniveau umrahmt ist, die mit dem zentralen Bereich erste und zweite Übergänge (J₁, J₂) bilden , die die besagte Hochspannung auszuhalten geeignet sind, wobei die ersten und zweiten Übergänge bis zur gleichen Hauptoberfläche der Anordnung zu beiden Seiten einer offenen Oberfläche des zentralen Bereiches reichen, und wobei eine Ausnehmung in der gesamten offenen Oberfläche geformt und mit einem Passivierungsglas (18) ausgefüllt ist, dadurch gekennzeichnet, daß die Oberfläche des Glases oberhalb der Kontur eines jeden Überganges mit einer Metallisierung (21, 22) bedeckt ist, die in Kontakt mit der Schicht des zweiten, diesem Übergang entsprechenden Leitungstypes ist und die sich über eine Entfernung (L), die klein gegenüber der Dicke (e) des zentralen Bereiches ist, auf der Oberfläche des zentralen Bereiches erstreckt.

2. Hochspannungshalbleiter-Anordnung nach Anspruch 1, die einen Thyristor bildet, der ausgehend von einem schwach dotierten, den zentralen Bereich bildenden Substrat (N⁻) ausgebildet ist mit einer zweiten Schicht vom P-Typ (P₂), die auf der gesamten unteren Oberfläche des Thyristors ausgebildet ist, und tiefen Diffusionen (P₃) vom P-Typ, die sich an der Peripherie des Thyristors vereinigen, wobei der Kontaktbereich zwischen der Diffusionssenke gegenüber der zweiten Schicht vom P-Typ und dem zentralen Bereich den äußeren offenen Bereich des zweiten Überganges bildet und ein erster Bereich (P₁) vom P-Typ in einem Bereich der oberen Oberfläche des Hauptbereiches gebildet wird, ohne in Kontakt mit der Senke zu treten, der an Oberfläche mit dem Zentralbereich den ersten Übergang bildet, wobei ein Kathodenbereich (N⁺) in dem ersten Bereich vom P-Typ gebildet wird.

## Claims

1. A high voltage semiconductor component having a low stray current comprising a central region (N⁻) of a first conductivity type with a low doping level surrounded by layers (P₁, P₃) of the second conductivity type with an higher doping level forming with said central region first and second junctions (J₁, J₂) liable to hold said high voltage, wherein the first and second junctions have an apparent perimeter on a main surface of the component, on both sides of an apparent surface of said central region, and wherein a groove is formed in all said apparent surface and is filled with a passivation glass (18), characterized in that the surface of the glass is covered, above the perimeter of each junction, with a metallization (21, 22) contacting the layer of the second conductivity type corresponding to this junction, and extending on a distance (L), small with respect to the thickness (e) of the central region, above the surface of said central region.

2. A high voltage semiconductor component according to claim 1, forming a thyristor formed from a lowly doped (N⁻) substrate constituting said central region, a second P-type layer (P2) being formed on all the lower surface of the thyristor and deep P-type diffusions (P3) joigning at the periphery of the thyristor, the contact region between the diffused well opposite to said second P-type layer and said central region forming the apparent perimeter of the second junction, and a first P-type layer (P1) being formed in a part of the upper surface of the main region, not contacting the well and forming, at the surface of the component, said first junction with said central region, a cathode region (N⁺) being formed in the first P-type region.
